# EUROPEAN PATENT APPLICATION

(11) **EP 4 799 974 A1**
(43) Date of publication of application: **02.09.2026**
(21) Application number: 25160511.9
(22) Date of filing: 27.02.2025
(51) Int. Cl.: B81B 3/00, G03F 7/00, G02B 26/08

(54) **LINKAGE FOR AN ACTUATOR**

(71) Applicant: ASML Netherlands B.V., 5500 AH Veldhoven (NL)
(72) Inventor: PNINI, Boaz, 5500 AH Veldhoven (NL)
(74) Representative: ASML Netherlands B.V.

(57) **Abstract**

A linkage for an actuator is discloses, which comprises: a first portion; a second portion; and a hinge, wherein the first portion is connected to the second portion via the hinge. The hinge comprises at least one hinge portion. The or each hinge portion comprises a plurality of blade flexures extending from a first rigid body portion to a second rigid body portion. The plurality of blade flexures are generally mutually parallel. At least two of the plurality of blade flexures have different lengths in a direction extending between the first rigid body portion and the second rigid body portion. An actuator comprising such a linkage is also disclosed. The actuator may comprise a micro-electromechanical system (MEMS).

## Description

### FIELD

The present invention relates to a linkage for an actuator. The present invention also relates to an actuator comprising the linkage. The actuator may comprise a micro-electromechanical system (MEMS). The actuator may comprise an electrostatic actuator. The linkage and/or actuator may comprise, or form part of, a reflective optical element (e.g. a mirror) to form a movable optical element. The present invention also relates to an apparatus comprising a plurality of such individually directable or movable optical elements. The apparatus may have particular application in an illumination system of an extreme ultraviolet (EUV) lithographic apparatus. The present invention also relates to such an illumination system. The present invention also relates to a lithographic apparatus, a metrology apparatus and/or an inspection apparatus comprising such an illumination system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern from a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

It is desirable to provide control over various properties of a radiation beam that is used in a lithographic apparatus to project a pattern onto a substrate. For example, it is desirable to control a dose of radiation that is delivered to the substrate. Furthermore, it is desirable to provide control over the shape (i.e. the spatial distribution) of the radiation beam in a plane of the patterning device. In addition, it is desirable to provide control over the angular distribution of the radiation beam in a plane of the patterning device. The angular distribution of the radiation beam in a plane of the patterning device may be referred to as an illumination mode or pupil and this may be chosen in dependence on the pattern being imaged to increase image contrast on the substrate.

The spatial and/or angular distribution of the radiation beam in a plane of the reticle (patterning device) may be achieved using an illumination system. In some EUV lithographic systems the illumination system comprises one or more arrays of movable mirrors, which may each be individually actuatable.

It may be desirable to provide a new, alternative linkage or actuator (for example for a movable optical element or mirror that may form part of an illumination system) that at least partially addresses one or more problems associated with prior art arrangements whether identified herein or otherwise.

### SUMMARY

According to a first aspect of the present disclosure there is provided a linkage for an actuator, the linkage comprising: a first portion; a second portion; and a hinge, wherein the first portion is connected to the second portion via the hinge and wherein the hinge comprises at least one hinge portion, the or each hinge portion comprising a plurality of blade flexures extending from a first rigid body portion of the linkage to a second rigid body portion of the linkage, wherein the plurality of blade flexures are generally mutually parallel and wherein at least two of the plurality of blade flexures have different lengths in a direction extending generally between the first rigid body portion and the second rigid body portion.

The first portion may be for connection to a first object. In use, the first portion may be rigidly connected to a first object. Alternatively, first portion may comprise the first object. Similarly, the second portion may be for connection to a second object. In use, the second portion may be rigidly connected to a second object. Alternatively, second portion may comprise the second object. The linkage may form part of an actuator for a movable (for example rotatable) mirror. In such example uses, the first object may comprise a mirror and the second object may comprise a base or support for the mirror. The hinge may allow the mirror to rotate relative to the base. The linkage may form part of a micro-electromechanical system (MEMS).

The linkage according to the first aspect is advantageous, as now discussed.

In general, the hinge (comprising at least one hinge portion) allows the linkage to be distorted (for example by a force applied by an actuation mechanism) so as to cause relative movement of the first and second portions. In use, this may allow a mirror to rotate relative to a base. A relative movement of the first and second portions may be characterized by a distortion parameter that characterizes a change in a relative position of the first and second members relative to an equilibrium relative position. For example, the distortion parameter may comprise an angular displacement, *θ*, from the equilibrium relative position. A hinge portion comprising a single blade flexure would be expected to generally obey Hooke's law such that a restoring torque of the single blade flexure may be generally linearly proportional to the distortion parameter, *θ*.

Since at least two of the plurality of blade flexures (of at least one hinge portion) have different lengths there will be a conflict which will depend on the distortion parameter, *θ*. This results in a restoring torque that has a non-linear dependence on the distortion parameter, *θ*. This is advantageous because, as explained further below, some actuation mechanisms (for example electrostatic comb drives) also produce a non-linear actuation torque, i.e. an actuation torque that has a non-linear dependence on the distortion parameter, *θ*. Advantageously, the linkage according to the first aspect provides an arrangement wherein a dependence of the restoring torque of the (or each) hinge portion on the distortion parameter, *θ*, is such that it at least partially compensates for such a non-linear actuation torque. In turn, this will significantly simplify a control loop for the actuator.

Furthermore, by using blade flexures for the hinge portion(s), the linkage according to the first aspect provides a particularly simple solution to provide such a non-linear restoring torque response. In particular, with such an arrangement the or each hinge portion may be formed as a monolithic structure. For example, the or each hinge portion may be formed from a single crystal, for example a silicon crystal. The plurality of blade flexures may be formed from portions of the monolithic structure or single crystal that have at least one relatively thin dimension and which accommodate relative movement of the first and second rigid body portions.

It will be appreciated that, in use, a linkage may be distorted by forces (for example applied by an actuation mechanism). It will be further appreciated that some portions of a linkage may be more flexible (less rigid) than other portions of the linkage. When the linkage is subjected to load forces these more flexible portions may be distorted, which may result in relative movement of the first portion and the second portion. Similarly, when the linkage is subjected to load forces the less flexible portions may experience negligible distortion; a rigid portion is intended to mean such a less flexible portion. The rigid body portions may have a flexural rigidity that is at least a factor of 10 greater than that of the plurality of blade flexures.

The or each hinge portion may be formed as a monolithic structure.

For example, the or each hinge portion may be formed from a single crystal, for example a silicon crystal.

At least a part of the first rigid body portion, at least a part of the second rigid body portion and the plurality of blade flexures of the or each hinge portion may be formed from a single crystal.

The plurality of blade flexures may be formed from portions of the monolithic structure or single crystal that have at least one relatively thin dimension and which accommodate relative movement of the first and second rigid body portions.

In some embodiments the hinge is of the form of a Cardan joint or a universal joint.

The hinge may be such that the first portion can rotate relative to the second portion in two degrees of freedom.

A first degree of freedom may allow the first portion to rotate about a first axis relative to the second portion. The first axis may extend in a direction that is referred to as a y-direction. A second degree of freedom may allow the first portion to rotate about a second axis relative to the second portion. The second axis may extend in a direction that is referred to as an x-direction.

The linkage may further comprise an intermediate portion. The hinge may comprise at least two hinge portions of the type described above, the at least two hinge portions comprising: at least one first hinge portion wherein the first rigid body portion of the or each at least one first hinge portion forms at least a part of the first portion and the second rigid body portion of the or each at least one first hinge portion forms at least a part of the intermediate portion; and at least one second hinge portion wherein the first rigid body portion of the or each at least one first hinge portion forms at least a part of the intermediate portion and the second rigid body portion of the or each at least one first hinge portion forms at least a part of the second portion.

The first portion may be rotatable relative to the intermediate portion about a first degree of freedom. The first degree of freedom may allow the first portion to rotate about a first axis relative to the second portion. The first axis may extend in a direction that is referred to as a y-direction. The second portion may be rotatable relative to the intermediate portion about a second degree of freedom. The second degree of freedom may allow the first portion to rotate about a second axis relative to the second portion. The second axis may extend in a direction that is referred to as an x-direction. Therefore, advantageously, this provides an arrangement wherein the hinge can allow the first portion to rotate relative to the second portion in two independent degrees of freedom.

The linkage may further comprise an intermediate portion. The hinge may comprises: (a) at least one first hinge portion comprising a plurality of blade flexures extending from a rigid body portion that forms at least a part of the first portion to a rigid body portion that forms at least a part of the intermediate portion, wherein the plurality of blade flexures are generally mutually parallel and wherein at least two of the plurality of blade flexures have different lengths in a direction extending generally between the rigid body portion that forms at least a part of the first portion and the rigid body portion that forms at least a part of the intermediate portion; and (b) at least one second hinge portion comprising: a plurality of blade flexures extending from a rigid body portion that forms at least a part of the intermediate portion to a rigid body portion that forms at least a part of the second portion, wherein the plurality of blade flexures are generally mutually parallel and wherein at least two of the plurality of blade flexures have different lengths between the rigid body portion that forms at least a part of the intermediate portion and the rigid body portion that forms at least a part of the second portion.

The at least one first hinge portion may allow the first portion to rotate relative to the second portion in a first degree of freedom and the at least one second hinge portion may allow the first portion to rotate relative to the second portion in a second, different degree of freedom.

In general, the first portion may comprise at least one rigid body portion (which may be for connection to a first object). The or each such at least one rigid body portion of the first portion may form part of one of the at least one hinge portion. In some embodiments, the first portion may comprise a plurality of rigid body portions (for example two rigid body portions). In some embodiments, the first portion may further comprise a first object connected to the at least one rigid body portion.

Similarly, in general, the second portion may comprise at least one rigid body (which may be for connection to a second object). The or each such at least one rigid body of the second portion may form part of one of the at least one hinge portion. In some embodiments, the second portion may comprise a plurality of rigid bodies (for example two rigid bodies). In some embodiments, the second portion may further comprise a second object connected to the at least one rigid body.

The first portion may comprise a first member and the second portion may comprise a second member.

The first member may comprise a mirror. The second member may comprise a base. The first member may be separated from the second member in a direction, which may be referred to as a z-direction.

The first portion may comprise a member having two larger dimensions in first and second directions, which define a plane of the member.

The member of the first portion (which may be referred to as a first member) may be described as being planar. It will be appreciated that as used herein an object being generally planar is intended to mean that it has two dimensions (in first and second directions) that are larger than a third dimension of the object. The first and second directions may be referred to as the x-direction and the y-direction respectively. The third direction may be referred to as a z-direction.

The member of the first portion (which may be referred to as a first member) may comprise a mirror.

The hinge may be disposed at a central portion of the plane of the member of the first portion.

The member of the first portion may comprise or define a reflective optical surface.

The reflective optical surface may be reflective for extreme ultraviolet (EUV) radiation. The reflective optical surface may comprise a multilayer mirror (also known as a Bragg mirror). The reflective optical surface may have dimensions of the order of 1 mm by 1 mm.

At least one hinge portion of the linkage may have a non-linear response.

That is, a restoring force applied by said at least one hinge portion has a non-linear dependence on a distortion parameter, *θ*, that characterizes a change in a relative position of the first and second members relative to an equilibrium relative position.

As the plurality of blade flexures of at least one hinge portion are distorted, each one will exert a torque exerted on the first portion and/or second portions that will tend to cause rotation of the first portion relative to the second portion about a direction in which the first member is separated from the second member (referred to herein generally as a z-direction).

The plurality of blade flexures of at least one hinge portion may be arranged such that as they are distorted torques exerted on the first portion and/or second portions by the plurality of blade flexures that cause rotation of the first portion relative to the second portion about a direction in which the first member is separated from the second member at least partially cancel out.

That is, the (Rz) torques applied by the plurality of blade flexures at least partially cancel out such that a total (Rz) torque is less than the individual torques applied by individual blade flexures.

The plurality of blade flexures of at least one hinge portion may be arranged such that as they are distorted a total torque exerted on the first portion and/or second portions by the plurality of blade flexures that cause rotation of the first portion relative to the second portion about a direction in which the first member is separated from the second member is zero.

According to a second aspect of the present disclosure there is provided an actuator comprising: the linkage according to the first aspect of the present disclosure; and an actuation mechanism operable to apply an actuation force so as to cause relative movement of first and second portions of the linkage.

The actuator according to the second aspect may be used to support, and control an orientation of, a rotatable mirror. For example, the first portion may support a mirror and the second portion may be, or be connected to, a fixed support. In use, the actuation mechanism may be used to apply an actuation force, or actuation torque, in order to achieve a desired orientation of the mirror relative to the fixed support.

In general, the actuation force applied by the actuator may be dependent on an actuation parameter and a relative position of the first and second portions. For example, the actuator may be an electrostatic actuator and the actuation force may be dependent on an applied voltage. The actuation parameter may be dependent on the applied voltage; for example the actuation parameter may be *Vⁿ*, where V is the applied voltage. Furthermore, the actuation force may be dependent on a relative position of the first and second portions. For example, the actuation force, *Fₐ,* may be given by *Fₐ = g*₁ · *θ* · *Vⁿ*, where *g*₁ is a gain of the actuator and *θ* is a deformation parameter that characterizes a relative position of the first and second members. If *g*₁ is a constant then the actuation force may be considered to have a linear dependence on the relative position of the first and second portions.

The hinge portion(s) couple the first and second portions together and may apply a restoring force in the event that an actuation force is applied. The restoring force may generally act so as to oppose the actuation force and to urge the first and second portions back to a nominal or equilibrium relative position.

Upon application of an actuation force, the actuator will adopt a steady-state position in which the sum of the forces acting upon the second member is zero. That is, in steady state, *Fₐ = -Fᵣ.*

At least one hinge portion of the linkage may have a non-linear response such that a restoring force applied by said at least one hinge portion at least partially compensates for a non-linear dependence of the actuation force on a relative position of the first and second members.

It will be appreciated that the relative position of the first and second members may be a relative angular position of the first and second members.

The actuator may be any type of actuator but in one example embodiment it may comprise an electrostatic actuator, for example an electrostatic comb actuator.

The actuator may comprise an electrostatic actuator and movement of the first portion relative to the second portion may be achieved by controlling a potential difference between one of more actuator conductors disposed on the second portion and one or more corresponding actuator conductors disposed on the first portion.

The actuator may comprise a comb-drive.

The actuator may comprise a micro-electromechanical system.

The actuator may further comprise a controller operable to control a voltage of one or more components of the actuation mechanism.

The actuator may further comprise a voltage supply operable to apply a voltage to one or more components of the actuation mechanism.

According to a third aspect of the present disclosure there is provided an apparatus comprising: a plurality of individual optical elements, each comprising the linkage according to the first aspect of the present disclosure and/or an actuator according to the second aspect of the present disclosure; and a support; wherein a second portion of each of the plurality of individual optical elements is supported by the support.

The apparatus according to the third aspect of the present disclosure may be for use in an illumination system of a lithographic apparatus.

Such an arrangement may be referred to as a MEMS micro-mirror array.

The apparatus may comprise a reflective optical surface supported by the first portion of at least one of the plurality of individual optical elements.

In some embodiments, a reflective optical surface is supported by the first portion of each of the plurality of individual optical elements.

The reflective optical surface may be reflective for extreme ultraviolet (EUV) radiation. The reflective optical surface may comprise a multilayer mirror (also known as a Bragg mirror). The reflective optical surface may have dimensions of the order of 1 mm by 1 mm.

The apparatus may further comprise a controller operable to control a voltage of one or more components of the actuation mechanism of at least one of the plurality of individual optical elements.

In some embodiments, the controller may be operable to control a voltage of one or more components of the actuation mechanism of each of the plurality of individual optical elements.

The apparatus may further comprise a voltage supply operable to apply a voltage to one or more components of the actuation mechanism of at least one of the plurality of individual optical elements.

In some embodiments, the voltage supply may be operable to apply a voltage to one or more components of the actuation mechanism of each of the plurality of individual optical elements.

According to a fourth aspect of the present disclosure there is provided an illumination system comprising at least one apparatus according to the third aspect of the present disclosure.

According to a fifth aspect of the present disclosure there is provided a lithographic apparatus comprising the illumination system according to the fourth aspect of the present disclosure.

According to a sixth aspect of the present disclosure there is provided a metrology apparatus comprising the illumination system according to the fourth aspect of the present disclosure.

According to a seventh aspect of the present disclosure there is provided an inspection apparatus comprising the illumination system according to the fourth aspect of the present disclosure.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a generally circular portion of the field facet mirror device of the lithographic system shown in Figure 1, showing a central obscuration portion two portions which receive radiation;
- Figure 2B shows an example shape of a field facet for a faceted field mirror device in a known EUV lithographic apparatus of the form shown in Figure 1;
- Figure 3A is a schematic cross sectional view of an actuator according to an embodiment of the present disclosure;
- Figure 3B is a plan view of the actuator shown in Figure 3A;
- Figure 3C is a cross sectional view of an example of the actuator shown in Figures 3A and 3B in an x-y plane which passes through the actuation mechanism and the damping system; and
- Figure 4A shows a schematic side view of a first new linkage according to an embodiment of the present disclosure;
- Figure 4B shows a schematic top view of the first new linkage shown in Figure 4A;
- Figure 5A shows a first schematic side view of a second new linkage according to an embodiment of the present disclosure as viewed in the direction of the positive y-direction;
- Figure 5B shows a second schematic side view of the second new linkage shown in Figure 5A as viewed in the direction of the positive x-direction;
- Figure 5C shows a third schematic side view of the second new linkage shown in Figures 5A and 5B as viewed in the direction of the negative y-direction;
- Figure 5D shows a fourth schematic side view of the second new linkage shown in Figures 5A to 5C as viewed in the direction of the negative x-direction;
- Figure 5E shows a schematic top view of the new linkage shown in Figures 5A to 5D;
- Figure 6A shows a schematic top view of a third new linkage system according to an embodiment of the present disclosure;
- Figure 6B shows a schematic top view of a fourth new linkage system according to an embodiment of the present disclosure;
- Figure 6C shows a schematic top view of a fifth new linkage system according to an embodiment of the present disclosure;
- Figure 7 schematically shows an actuator comprising a linkage of the type shown in Figures 4A to 6C according to an embodiment of the present disclosure; and
- Figure 8 schematically shows an apparatus according to an embodiment of the present disclosure comprising a plurality of individual optical elements, each comprising a linkage of the type shown in Figures 4A to 6C and/or an actuator of the type shown in Figure 7.

### DETAILED DESCRIPTION

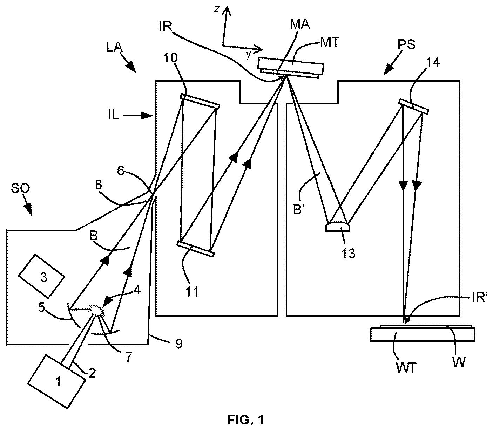

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

The illumination region IR is in a field plane in which the reticle MA is disposed during a lithographic exposure. Therefore, the illumination region IR may be referred as a reticle-level or object-level illumination region IR. It will be appreciated that projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled. In a conventional illumination mode, the radiation uniformly fills a circular region of the illumination pupil plane centred on the optical axis such that each point on the patterning device is illuminated by a solid cone of light. In dipole illumination mode, the radiation fills two regions of the illumination pupil plane that are spaced apart from, and on opposite sides to, the optical axis. Many other illumination modes are known. In principle, an optimum illumination mode can be defined to image a given pattern under given conditions. Therefore, it is desirable to provide flexibility in the illumination mode.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

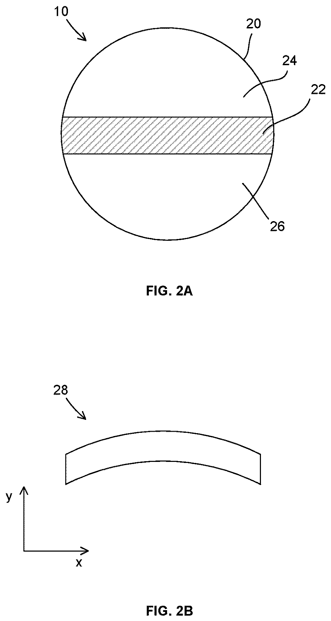

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2A a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

A known faceted field mirror device 10 used in an EUV lithographic apparatus of the type shown in Figure 1 is now described with reference to Figures 2A and 2B.

In some known EUV lithographic apparatus, the faceted field mirror device 10 comprises a plurality of field facets. In particular, in such known EUV lithographic apparatus, the portions 24, 26 of the faceted field mirror device 10 that receive radiation from the radiation source SO are provided with a plurality of field facets. For example, the portions 24, 26 of the faceted field mirror device 10 that receive radiation from the radiation source SO may be provided with of the order of 100 field facets (for example 300 field facets). In general, in the plane of the faceted field mirror device 10 each field facet may have a shape that generally matches an entrance pupil of the projection system PS. In a plane of the faceted field mirror device 10 each field facet may have a curved shape 28, as shown in Figure 2B. In general, in the plane of the faceted field mirror device 10 each field facet may have an elongate shape having a longer dimension in an x-direction and a shorter dimension in a y-direction. Each field facet comprises a mirror that may be arranged to image the intermediate focus 6 onto the faceted pupil mirror device 11. To achieve this, the field facets may, for example, be concave.

The faceted pupil mirror device 11 comprises a plurality of pupil facets. The faceted pupil mirror device 11 is arranged to project an image of each field facet of the faceted field mirror device 10 onto an illumination region IR (also referred to as the slit or illumination slit) at the patterning device MA. The illumination system IL is configured so that each field facet is imaged on the illumination region IR in an overlapping manner. The overlap of the images of the field facets at least partially evens out irregularities in the intensity distribution of the radiation beam B provided by the radiation source SO.

The illumination region IR may be curved or straight. In general, in a scanning lithographic apparatus LA, the illumination region IR is elongate having a longer dimension and a shorter dimension. The shorter dimension may coincide with a scanning direction of the support structure MT and the longer dimension may coincide with a non-scanning direction. The illumination region IR is indicated in Figure 1, which shows the patterning device in cross section. The longer dimension (in the x-direction) of the illumination region IR is perpendicular to the plane of Figure 1 and the shorter dimension (in the y-direction) of the illumination region IR lies in the plane of Figure 1.

It has been proposed to use a faceted field mirror device 10 having a large number of individually directable or movable reflective optical elements so as to provide better control over the illumination modes of the lithographic apparatus LA. It has been further proposed to use a faceted pupil mirror device 11 having a large number of individually directable or movable reflective optical elements so as to provide better control over the illumination modes of the lithographic apparatus LA.

Each of the independently movable reflective optical elements may comprise a micro-electromechanical system (MEMS). Therefore, the faceted field mirror device 10 and/or the faceted pupil mirror device 11 may be considered to comprise a MEMS micro-mirror array.

Each of the reflective optical elements may, for example, be a multilayer mirror. Each of the reflective optical elements may be configured such that its orientation can be controlled about one or two axes so that a direction to which it directs radiation can be controlled. For example, each of the reflective optical elements may have one or more actuators by which the reflective optical element can be rotated about an axis or two orthogonal axes. Thereby, each of the reflective optical elements can be controlled to direct radiation in a specific direction.

The faceted field mirror device 10 may comprise of the order of 100,000 independently movable reflective optical elements. These reflective optical elements may substantially cover the portions 24, 26 of the faceted field mirror device 10 that receive radiation from the radiation source SO (see Figure 2A and accompanying discussion).

In some known lithographic apparatus, such a faceted field mirror device 10 comprising a MEMS micro-mirror array is used as follows. The two-dimensional array of independently movable reflective optical elements provided on the faceted field mirror device 10 may be considered to comprise a plurality of groups of reflective optical elements. Each group of reflective optical elements may comprise a plurality of adjacent independently movable reflective optical elements on the faceted field mirror device 10. Each of the plurality of groups of reflective optical elements may be referred to as a cluster of reflective optical elements.

Each group of reflective optical elements may be configured generally to replace one of the field facets discussed above. For example, each group may cover a region of the faceted field mirror device 10 that generally corresponds to the shape of a field facet of the known faceted field mirror device 10 discussed above (for example a region having a shape generally the same as the shape 28 shown in Figure 2B). It will be appreciated that each of the reflective optical elements may be generally square or rectangular in shape and therefore if the group is arranged as a generally curved elongate region of the faceted field mirror device 10 (similar to the shape 28 shown in Figure 2B), the shape may have jagged or pixelated edges along the curved sides of the shape. Furthermore, the orientations of the reflective optical elements within each group may be configured so as to provide an equivalent optical power or concave shape to a field facet of an existing faceted field mirror device 10. Alternatively, in some embodiments, each group may cover a region of the faceted field mirror device 10 that generally corresponds to the shape of a portion of a field facet of the known faceted field mirror device 10 discussed above.

Each of the plurality of groups may be referred to as a field facet mirror or a virtual field facet mirror. There may be of the order of 100, for example 300, groups of independently movable reflective optical elements. Each group may comprise of the order of 1000 independently movable reflective optical elements. For example, in one embodiment each group may comprise 10 rows of independently movable reflective optical elements, each row having 100 independently movable reflective optical elements.

The plurality of adjacent independently movable reflective optical elements in each group substantially cover a continuous region of the faceted field mirror device 10. It will be appreciated that this may mean that any gaps between adjacent reflective optical elements may be minimal.

A shape of a continuous region of the first optical component covered by the plurality of adjacent independently movable reflective optical elements in a group of independently movable reflective optical elements may be referred to as a shape of that group of independently movable reflective optical elements. The shape of each of the groups of independently movable reflective optical elements may generally correspond to a shape of the illumination region IR (in a similar manner to the shape of each of the field facets described above generally corresponding to a shape of the illumination region IR).

Each of the plurality of groups of independently movable reflective optical elements may have substantially the same size and shape. In some embodiments, the shape of each of the plurality of groups may be curved. In some embodiments, each of the plurality of groups may be generally rectangular in shape.

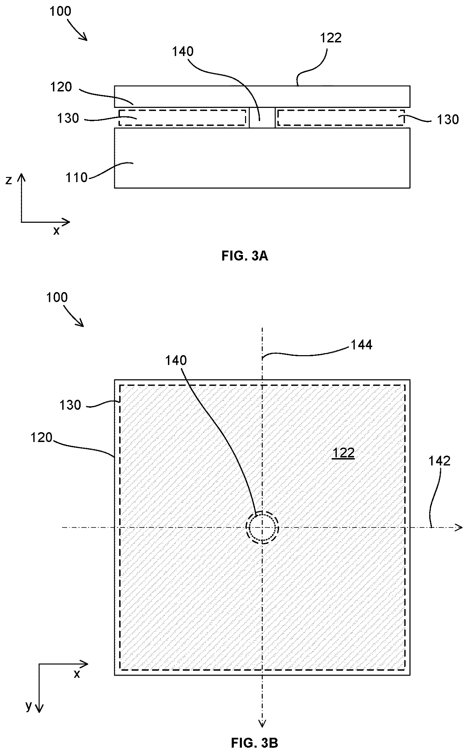

Some embodiments of the present disclosure relate to a new linkage for an actuator. Some embodiments of the present disclosure relate to an actuator comprising the new linkage. The actuator may be suitable for actuating the movable reflective optical elements of such MEMS micro-mirror arrays that may form the faceted field mirror device 10 and/or the faceted pupil mirror device 11. Embodiment of actuators that the new linkage may form part of are now described with reference to Figures 3A to 3C.

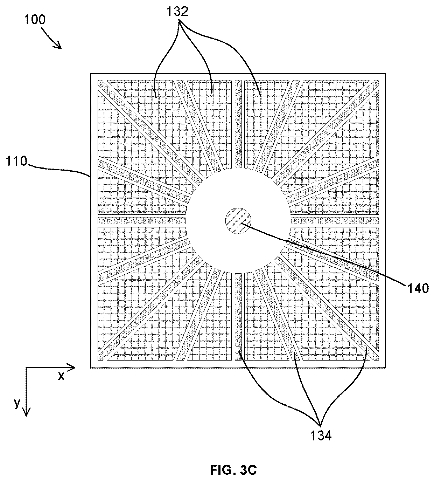

Figure 3A is a schematic cross sectional view of an actuator 100. Figure 3B is a plan view of the new actuator 100. A consistent set of right-handed Cartesian axes are used in Figures 3A, 3B and 3C. The actuator 100 comprises: a first member 110; a second member 120; an actuation mechanism 130; and a hinge 140. The actuation mechanism 130 is configured to move the second member 120 relative to the first member 110.

The first member 110 is connected to the second member 120 via the hinge 140. At least a part of each of the first member 110 and the second member 120 and the hinge 140 may be formed as a monolithic structure. For example, at least a part of the first member 110, at least a part of the second member 120 and the hinge 140 may be formed from a single crystal, for example a silicon crystal.

The actuator 100 may be any type of actuator but in one example embodiment it may comprise a micro-electromechanical system (MEMS). With such an embodiment, at least a part of each of the first and second members 110, 120 may be formed as a monolithic structure. For example, at least a part of each of the first and second members 110, 120 may be formed from a single crystal, for example a silicon crystal. The first and second members 110, 120 may be connected by a portion of the monolithic structure or single crystal by a portion of material 150 that accommodates relative movement of the first and second members and which may be referred to as a hinge 140.

Although the actuation mechanism 130 and the hinge 140 cannot be seen in the plan view of Figure 3B, the footprint of each of these in the x-y plane is shown as dotted lines in Figure 3B.

In some embodiments, the first and second members 110, 120 each have two larger dimensions in first and second directions (the x-direction and the y-direction respectively in Figures 3A and 3B). The first and second members 110, 120 are separated in a third direction (the z-direction in Figure 3A). The first and second directions may be considered to define a plane of the actuator 100. That is, the plane of the actuator 100 may be the x-y plane (or any plane parallel thereto).

The first and second members 110, 120 may be described as being planar. It will be appreciated that as used herein an object being generally planar is intended to mean that it has two dimensions (in first and second directions, for example the x-direction and the y-direction) that are larger than a third dimension of the object. The third direction may be referred to as a z-direction.

In some embodiments, an upper surface 122 of the second member 120 (i.e. a surface of the second member that faces away from the first member 110) may comprise a reflective optical surface 122.

The reflective optical surface 122 may be reflective for extreme ultraviolet (EUV) radiation. The reflective optical surface 122 may comprise a multilayer mirror (also known as a Bragg mirror). The reflective optical surface 122 may have dimensions of the order of 1 mm by 1 mm.

The actuator 100 may comprise a micro-electromechanical system.

The hinge 140 may be configured so as to allow the second member 120 to rotate about a first axis 142 relative to the first member 110. The first axis 142 may be generally perpendicular to the third direction (the z-direction). The first axis 142 may extend in a direction that is parallel to the x-direction in Figures 3A and 3B.

The hinge 140 may also be configured so as to allow the second member 120 to rotate about a second axis 144 relative to the first member 110, wherein the second axis 144 is not parallel to the first axis 142. In this example, the second axis 144 is perpendicular to the first axis 142. The second axis 144 is generally perpendicular to the third direction (the z-direction). The second axis 144 may extend in a direction that is parallel to the y-direction in Figure 3B.

In some embodiments the hinge 140 is of the form of a Cardan joint or a universal joint (allowing rotation of the second member 120 relative to the first member 110 about either the first axis 142 or the second axis 144).

As shown in this example, the hinge 140 may be disposed at a central portion of the plane of the actuator 100 (i.e. a central portion of the actuator 100 in the x-y plane).

The actuator mechanism 130 may comprise any type of actuator but in one example embodiment it may comprise an electrostatic actuator, for example an electrostatic comb actuator.

In some embodiments, the actuation mechanism 130 comprises an electrostatic actuator. That is, movement of the second member 120 relative to the first member 110 may be achieved by controlling a potential difference between one or more actuator conductors disposed on the first member 110 and one or more corresponding actuator conductors disposed on the second member 120.

In some embodiments, the actuation mechanism 130 may comprise a comb-drive.

Figure 3C is a cross sectional view of an example of the new actuator 100 shown in Figures 3A and 3B in an x-y plane which passes through the actuation mechanism 130 and the hinge 140.

In this embodiment, the actuation mechanism 130 comprises an electrostatic actuator. The actuation mechanism 130 comprises a plurality of first actuator conductors 132 and a plurality of second actuator conductors 134. In this embodiment, the actuation mechanism 130 comprises sixteen first actuator conductors 132 and sixteen second actuator conductors 134 (although only three of each are labelled in Figure 3C to avoid overcomplicating the labels in the Figure). It will be appreciated that in alternative embodiments, different numbers of first actuator conductors 132 and second actuator conductors 134 may be provided.

In this (x-y) plane, the first actuator conductors 132 and the second actuator conductors 134 all extend generally radially from a center of the actuator 100. The first actuator conductors 132 extend from the first member 110 whereas the second actuator conductors 134 extend from the second member 120. This embodiment may be referred to as a comb-drive, for example a radial comb-drive.

With this embodiment, movement of the second member 120 relative to the first member 110 may be achieved by controlling voltages of the each of the first and second actuator conductors 132, 134.

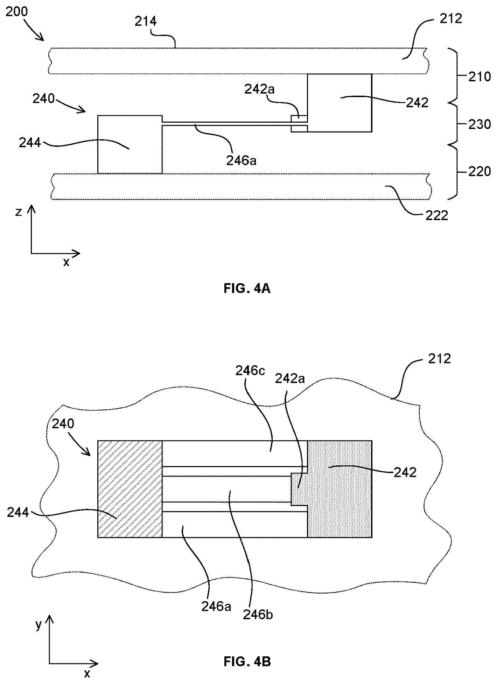

Some embodiments of the present disclosure relate to a new linkage for an actuator. The new linkage may form part of an actuator of the general type shown in Figures 3A to 3C. For example, it may form part of the actuator comprising the hinge 140. An embodiment of such a new linkage 200 is now described with reference to Figures 4A and 4B. Note that throughout Figures 4A and 4B a consistent set of right-handed Cartesian coordinates are used.

Figure 4A shows a side view of the new linkage 200 and Figure 4B shows a top view (as viewed from the top in Figure 4A). Note that, in order to aid a better understanding of the linkage 200, in Figure 4B an uppermost feature (a first object 212, discussed below) is schematically shown as being transparent. It will be appreciated that in practice this feature 212 may be opaque.

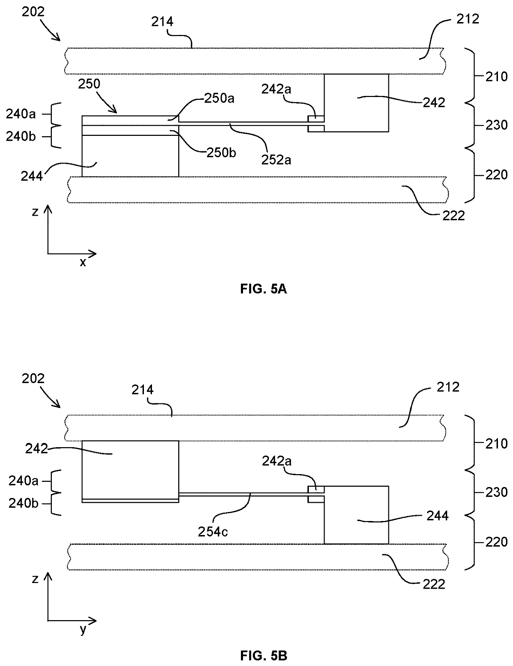

The linkage 200 comprises: a first portion 210, a second portion 220; and a hinge 230. The first portion 210 is connected to the second portion 220 via the hinge 230. The hinge comprises at least one hinge portion 240. In Figures 4A and 4B only a single hinge portion 240 is shown but, as will be discussed further below (with reference to Figures 5A to 6C), other embodiments may comprise a plurality of hinge portions.

Each hinge portion 240 comprises a plurality of blade flexures 246a, 246b, 246c extending from a first rigid body portion 242 to a second rigid body portion 244. The plurality of blade flexures 246a, 246b, 246c are generally mutually parallel. At least two of the plurality of blade flexures 246a, 246b, 246c have different lengths in a direction extending generally between the first rigid body portion 242 and the second rigid body portion 244 (i.e. in the x-direction). In particular, a central one of the blade flexures 246b has a shorter length in the x-direction than the two other blade flexures 246a, 246c. At least one of the rigid body portions 242, 244 may define one or more rigid protrusions or recesses to accommodate this difference in length of the blade flexures 246a, 246b, 246c in the x-direction. In particular, a rigid protrusion 242a is defined on the first rigid body portion 242 having an extent in the x-direction that generally matches a difference in extent in the x-direction of the central blade flexure 246b and the two other blade flexures 246a, 246c. It will be appreciated that any other combination of protrusions and/or recesses may be used to allow for an arrangement wherein at least two of the plurality of blade flexures 246a, 246b, 246c have different lengths in the x-direction.

The first portion 210 may be for connection to a first object. In use, the first portion 210 may be rigidly connected to a first object. Alternatively, as shown schematically in Figure 4A, first portion 210 may comprise the first object 212. Similarly, the second portion 220 may be for connection to a second object. In use, the second portion 220 may be rigidly connected to a second object. Alternatively, as shown schematically in Figure 4A, second portion 220 may comprise the second object 222. The linkage 200 may form part of an actuator for a movable (for example rotatable) mirror. In such example uses, the first object 212 may comprise a mirror and the second object 222 may comprise a base or support for the mirror. The hinge 230 may allow the mirror 212 to rotate relative to the base 222. The linkage may form part of a micro-electromechanical system (MEMS).

The linkage 200 shown in Figures 4A and 4B is advantageous, as now discussed.

In general, the hinge 230 (comprising at least one hinge portion 240) allows the linkage 200 to be distorted (for example by a force applied by an actuation mechanism) so as to cause relative movement of the first and second portions 210, 220. In use, this may allow a mirror 211 to rotate relative to a base 222. A relative movement of the first and second portions 210, 220 may be characterized by a distortion parameter that characterizes a change in a relative position of the first and second members 210, 220 relative to an equilibrium relative position. For example, the distortion parameter may comprise an angular displacement, *θ*, from the equilibrium relative position. A hinge portion comprising a single blade flexure would be expected to generally obey Hooke's law such that a restoring torque of the single blade flexure may be generally linearly proportional to the distortion parameter, *θ*.

Since at least two of the plurality of blade flexures 246a, 246b, 246c (of at least one hinge portion 240) have different lengths there will be a conflict which will depend on the distortion parameter, *θ*. This results in a restoring torque that has a non-linear dependence on the distortion parameter, *θ*. This is advantageous because, as explained further below, some actuation mechanisms (for example electrostatic comb drives) also produce a non-linear actuation torque, i.e. an actuation torque that has a non-linear dependence on the distortion parameter, *θ*. Advantageously, the linkage 200 of the type shown schematically in Figures 4A and 4B provides an arrangement wherein a dependence of the restoring torque of the (or each) hinge portion on the distortion parameter, *θ*, is such that it at least partially compensates for such a non-linear actuation torque. In turn, this will significantly simplify a control loop for the actuator.

Furthermore, by using blade flexures 246a, 246b, 246c for the hinge portion(s) 240, the new linkage 200 provides a particularly simple solution to provide such a non-linear restoring torque response. In particular, with such an arrangement the or each hinge portion 240 may be formed as a monolithic structure. For example, the or each hinge portion 240 may be formed from a single crystal, for example a silicon crystal. The plurality of blade flexures 246a, 246b, 246c may be formed from portions of the monolithic structure or single crystal that have at least one relatively thin dimension (the z-direction in Figures 4A and 4B) and which accommodate relative movement of the first and second rigid body portions 242, 244.

It will be appreciated that, in use, a linkage 200 may be distorted by forces (for example applied by an actuation mechanism). It will be further appreciated that some portions of a linkage 200 may be more flexible (less rigid) than other portions of the linkage 200. When the linkage 200 is subjected to load forces these more flexible portions may be distorted, which may result in relative movement of the first portion 210 and the second portion 220. Similarly, when the linkage 200 is subjected to load forces the less flexible portions may experience negligible distortion; a rigid portion is intended to mean such a less flexible portion. The rigid body portions 242, 244 may have a flexural rigidity that is at least a factor of 10 greater than that of the plurality of blade flexures 246a, 246b, 246c.

In some embodiments, the or each hinge portion 240 may be formed as a monolithic structure. For example, the or each hinge portion 240 may be formed from a single crystal, for example a silicon crystal.

In some embodiments, at least a part of the first rigid body portion 242, at least a part of the second rigid body portion 244 and the plurality of blade flexures 246a, 246b, 246c of the or each hinge portion 240 may be formed from a single crystal. The plurality of blade flexures 246a, 246b, 246c may be formed from portions of the monolithic structure or single crystal that have at least one relatively thin dimension and which accommodate relative movement of the first and second rigid body portions 242, 244.

Note that the first and second rigid body portions 242, 244 may each form part of, and/or may be integrally formed with a part of, the first portion 210 or the second portion 220.

The hinge 230 of the embodiment shown in Figures 4A and 4B, allows the first portion 210 to rotate relative to the second portion 220 in about an axis that generally extends in a direction that is parallel to the y-direction.

In some embodiments, the hinge 230 is of the form of a Cardan joint or a universal joint, as now discussed.

In some embodiments, the hinge 230 may be such that the first portion 210 can rotate relative to the second portion 220 in two degrees of freedom, as now discussed with reference to Figures 5A to 6C. A first degree of freedom may allow the first portion 210 to rotate about a first axis relative to the second portion 220. The first axis may extend in a direction that is referred to as a y-direction. A second degree of freedom may allow the first portion 210 to rotate about a second axis relative to the second portion 220. The second axis may extend in a direction that is referred to as a y-direction.

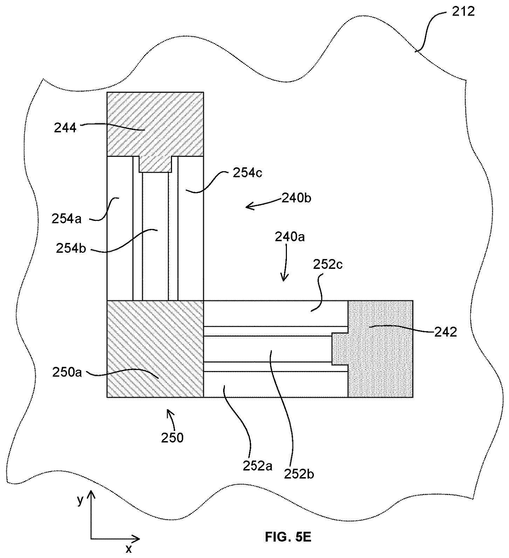

Another embodiment of a new linkage 202 is now described with reference to Figures 5A to 5E. The new linkage 202 shown in Figures 5A to 5E shares some features in common with the new linkage 200 shown in Figures 4A to 4B. Where any features of the new linkage 202 shown in Figures 5A and 5E are generally equivalent to features of the new linkage 200 shown in Figures 4A to 4B they share common reference numerals.

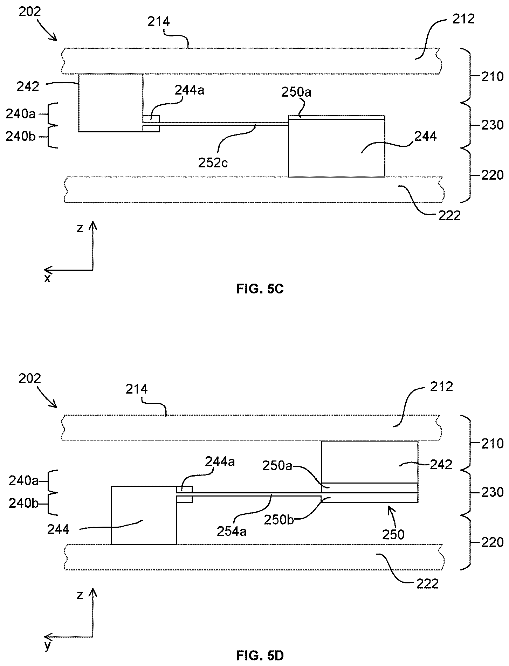

Note that throughout Figures 5A to 5E a consistent set of right-handed Cartesian coordinates are used. Figures 5A to 5D each shows a different side view of the linkage 202 viewed in the direction of: the positive y-direction (Figure 5A); the positive x-direction (Figure 5B); the negative y-direction (Figure 5C); and the negative x-direction (Figure 5D). Figure 5E shows a top view (as viewed from the top in Figures 5A to 5D). Note that, in order to aid a better understanding of the linkage 200, in Figure 5E an uppermost feature (a first object 212, discussed below) is schematically shown as being transparent. It will be appreciated that in practice this feature 212 may be opaque.

The linkage 202 comprises: a first portion 210, a second portion 220; and a hinge 230. The first portion 210 is connected to the second portion 220 via the hinge 230. The hinge 230 comprises two hinge portions 240. As mentioned above, other embodiments may comprise a different number of hinge portions. The linkage 202 further comprises an intermediate portion 250.

The hinge comprises: a first hinge portion 240a and a second hinge portion 240b.

The first hinge portion 240a comprises a plurality of blade flexures 252a, 252b, 252c extending from a rigid body portion 242 that forms at least a part of the first portion 210 to a rigid body portion 250a that forms at least a part of the intermediate portion 250. The plurality of blade flexures 252a, 252b, 252c are generally mutually parallel. At least two of the plurality of blade flexures 252a, 252b, 252c have different lengths in a direction extending generally between the rigid body portion 242 that forms at least a part of the first portion 210 and the rigid body portion 250a that forms at least a part of the intermediate portion 250 (the x-direction in Figures 5A to 5E). In particular, a central one of the blade flexures 252b has a shorter length in the x-direction than the two other blade flexures 252a, 252c. At least one of the rigid body portions 242, 250a may define one or more rigid protrusions or recesses to accommodate this difference in length of the blade flexures 252a, 252b, 252c in the x-direction. In particular, a rigid protrusion 242a is defined on the rigid body portion 242 that forms at least a part of the first portion 210, the rigid protrusion 242a having an extent in the x-direction that generally matches a difference in extent in the x-direction of the central blade flexure 252b and the two other blade flexures 252a, 252c. It will be appreciated that any other combination of protrusions and/or recesses may be used to allow for an arrangement wherein at least two of the plurality of blade flexures 252a, 252b, 252c have different lengths in the x-direction.

The second hinge portion 240b comprises a plurality of blade flexures 254a, 254b, 254c extending from a rigid body portion 250b that forms at least a part of the intermediate portion 250 to a rigid body portion 244 that forms at least a part of the second portion 220. The plurality of blade flexures 254a, 254b, 254c are generally mutually parallel. At least two of the plurality of blade flexures 254a, 254b, 254c have different lengths between the rigid body portion 250b that forms at least a part of the intermediate portion 250 and the rigid body portion 244 that forms at least a part of the second portion 220. In particular, a central one of the blade flexures 254b has a shorter length in the y-direction than the two other blade flexures 254a, 254c. At least one of the rigid body portions 250b, 244 may define one or more rigid protrusions or recesses to accommodate this difference in length of the blade flexures 254a, 254b, 254c in the y-direction. In particular, a rigid protrusion 244a is defined on rigid body portion 244 that forms at least a part of the second portion 220, the rigid protrusion 244a having an extent in the y-direction that generally matches a difference in extent in the y-direction of the central blade flexure 254b and the two other blade flexures 254a, 254c. It will be appreciated that any other combination of protrusions and/or recesses may be used to allow for an arrangement wherein at least two of the plurality of blade flexures 254a, 254b, 254c have different lengths in the y-direction.

The first portion 210 is rotatable relative to the intermediate portion 250 about a first degree of freedom. The first degree of freedom allows the first portion 210 to rotate about a first axis relative to the second portion 220. The first axis may extend in a direction that is generally parallel to the y-direction. The second portion 220 is rotatable relative to the intermediate portion 250 about a second degree of freedom. The second degree of freedom allows the first portion 210 to rotate about a second axis relative to the second portion 220. The second axis may extend in a direction that generally parallel to the y-direction. Therefore, advantageously, this provides an arrangement wherein the hinge 230 can allow the first portion 210 to rotate relative to the second portion 220 in two independent degrees of freedom.

The first hinge portion 240a allows the first portion 210 to rotate relative to the second portion 220 in a first degree of freedom (i.e. R_{y} or a rotation about a y-direction). Similarly, the second hinge portion 240b allows the first portion 210 to rotate relative to the second portion 220 in a second, different degree of freedom (i.e. Rₓ or a rotation about an x-direction).

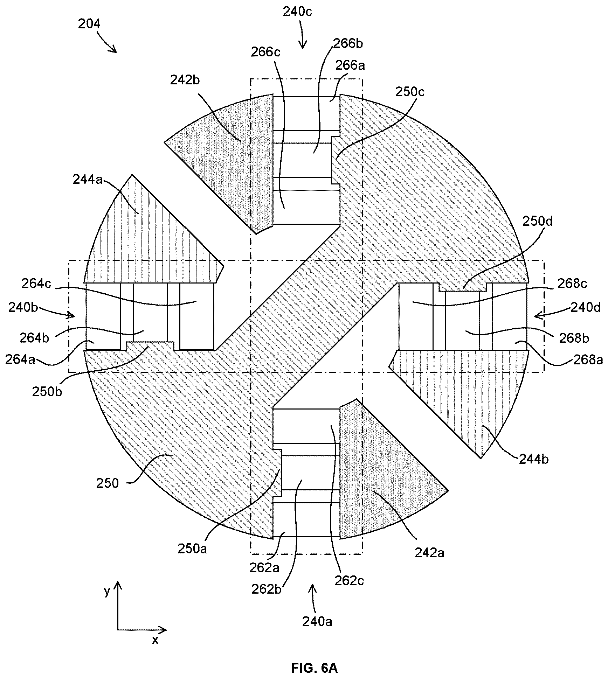

In general, the first portion 210 may comprise at least one rigid body portion 242 (which may be for connection to a first object 212). The or each such at least one rigid body portion 242 of the first portion 210 may form part of one of at least one hinge portion 240a. As discussed further below (with reference to Figures 6A to 6C), in some embodiments, the first portion 210 may comprise a plurality of rigid body portions (for example two rigid body portions). In some embodiments, the first portion 210 may further comprise a first object 212 connected to the at least one rigid body portion.

Similarly, in general, the second portion 220 may comprise at least one rigid body 244 (which may be for connection to a second object 222). The or each such at least one rigid body 244 of the second portion 220 may form part of one of at least one hinge portion 240b. As discussed further below (with reference to Figures 6A to 6C), in some embodiments, the second portion 220 may comprise a plurality of rigid bodies (for example two rigid bodies). In some embodiments, the second portion 220 may further comprise a second object 222 connected to the at least one rigid body.

As indicated schematically in Figures 4A to 5E, the first portion 210 of the new linkages 200, 202 according to the present disclosure may comprise a first member 212 and the second portion 220 of the new linkages 200, 202 according to the present disclosure may comprise a second member 222. The first member 212 may comprise a mirror. The second member 222 may comprise a base. The first member 212 may be separated from the second member 222 in a direction, which may be referred to as a z-direction.

In some embodiments, the first portion 210 may comprise a member 212 having two larger dimensions in first and second directions (the x- and y-directions in Figures 4A to 5E), which define a plane of the member. The member 212 of the first portion 210 (which may be referred to as a first member 212) may be described as being planar. It will be appreciated that as used herein an object being generally planar is intended to mean that it has two dimensions (in first and second directions) that are larger than a third dimension of the object. The third direction may be referred to as a z-direction.

The member 212 of the first portion 210 (which may be referred to as a first member) may comprise a mirror.

In some embodiments, of the linkages 200, 202 according to the present disclosure the hinge 230 may be disposed at a central portion of the plane of the member 212 of the first portion 210. For example, as discussed above with reference to Figures 3A to 3C, the hinge 140 may comprise a linkage 200, 202 according to the present disclosure and therefore the linkage 200, 202 according to the present disclosure may be provided in a corresponding position relative to the first member 210 as the hinge 140 is provided relative to second member 120 in Figures 3A to 3C.

In some embodiments, the member 212 of the first portion 210 of the linkage 200, 200 of the present disclosure may comprise or define a reflective optical surface 214. The reflective optical surface 214 may be reflective for extreme ultraviolet (EUV) radiation. The reflective optical surface 214 may comprise a multilayer mirror (also known as a Bragg mirror). The reflective optical surface 214 may have dimensions of the order of 1 mm by 1 mm.

In some embodiments, at least one hinge portion 240, 240a, 240b of the linkage 200, 202 of the present disclosure may have a non-linear response. That is, a restoring force applied by said at least one hinge portion 240, 240a, 240b may have a non-linear dependence on a distortion parameter, *θ*, that characterizes a change in a relative position of the first and second members 210, 220 relative to an equilibrium relative position.

As discussed above, in some embodiments, the first portion 210 may comprise a plurality of rigid body portions (for example two rigid body portions) and, similarly, the second portion 220 may comprise a plurality of rigid bodies (for example two rigid bodies).

An additional embodiment of a new linkage 204 is now described with reference to Figure 6A. The new linkage 204 shown in Figure 6A shares some features in common with the new linkage 202 shown in Figures 5A to 5E. Where any features of the new linkage 204 shown in Figure 6A are generally equivalent to features of the new linkage 202 shown in Figures 5A to 5E they share common reference numerals. Only the differences between the new linkage 204 shown in Figure 6A and the new linkage 202 shown in Figures 5A to 5E will be described in detail below.

In common with the linkage 202 shown in Figures 5A to 5E, the new linkage 204 shown in Figure 6A comprises an intermediate portion 250. The intermediate portion 250 is rigid and is intermediate the first and second portions (in a similar way that the intermediate portion 250 shown in Figures 5A to 5E is intermediate the first and second portions 210, 220).

In contrast to the linkage 202 shown in Figures 5A to 5E, the new linkage 204 shown in Figure 6A comprises two rigid body portions 242a, 242b that each forms at least a part of the first portion 210 and two rigid body portions 244a, 244b that each forms at least a part of the second portion 220.

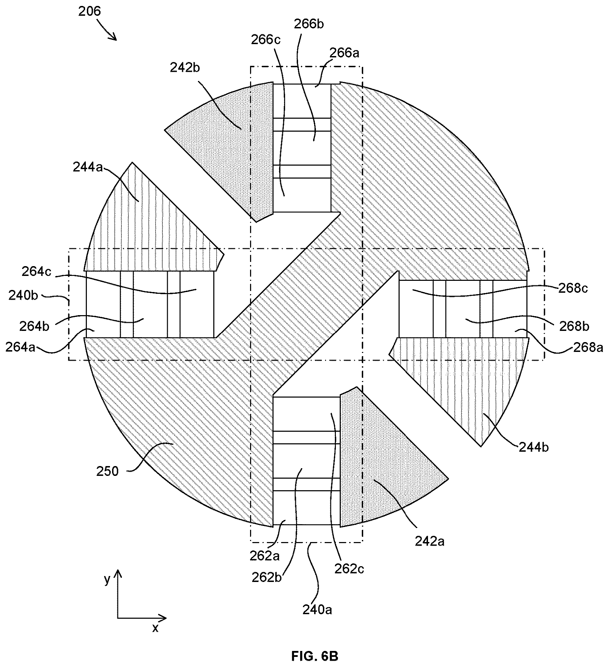

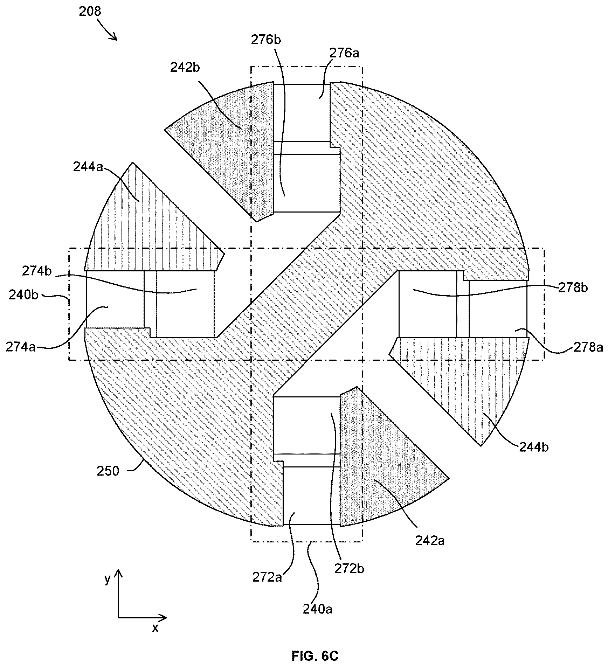

It will be apparent to the skilled person from a comparison with Figures 5A to 5E that the two rigid body portions 242a, 242b that each form at least a part of the first portion 210 are, in general, disposed at different positions in the z-direction (out of the plane of Figure 6A) to that of the two rigid body portions 244a, 244b that each form at least a part of the second portion 220. For example, the two rigid body portions 242a, 242b that each form at least a part of the first portion 210 may be at a higher z-position (i.e. more out of the page of Figure 6) and may, in use, each be connected to a common first object 212 (for example a mirror; not shown for clarity). Similarly, two rigid body portions 244a, 244b that each form at least a part of the second portion 220 may be at a lower z-position (i.e. further into the page of Figure 6A) and may, in use, each be connected to a common first object 222 (for example a base or support; not shown for clarity).

Furthermore, it will also be apparent to the skilled person from a comparison with Figures 5A to 5E that the intermediate portion 250 is disposed at a position in the z-direction that is intermediate to that of the z-positions of: (a) the two rigid body portions 242a, 242b that each form at least a part of the first portion 210; and (b) the two rigid body portions 244a, 244b that each form at least a part of the second portion 220.

It will be further appreciated by the skilled person that, in general, there will be some overlap in z-position between (a) the two rigid body portions 242a, 242b that each form at least a part of the first portion 210; and (b) the intermediate portion 250. It will be further appreciated by the skilled person that, in general, there will be some overlap in z-position between (a) the two rigid body portions 244a, 244b that each form at least a part of the second portion 220; and (b) the intermediate portion 250. In fact, the skilled person will understand that, at least in some embodiments, when the linkage 204 is in an equilibrium position, there will be a small overlap in z-position of: (a) the two rigid body portions 242a, 242b that each form at least a part of the first portion 210; (b) the two rigid body portions 244a, 244b that each form at least a part of the second portion 220; and (c) the intermediate portion 250. Furthermore, the skilled person will appreciate that when not disposed in an equilibrium position these overlaps in z-position may be subject to change.

The hinge 230 of the linkage 204 shown in Figure 6A may be considered to comprise: a first hinge portion 240a; a second hinge portion 240b; a third hinge portion 240c; and a fourth hinge portion 240d.

The first hinge portion 240a comprises three blade flexures 262a, 262b, 262c extending from a rigid body portion 242a that forms at least a part of the first portion 210 to a part of the intermediate portion 250. The plurality of blade flexures 262a, 262b, 262c are generally mutually parallel. At least two of the plurality of blade flexures 262a, 262b, 262c have different lengths in a direction extending generally between the rigid body portion 242a that forms at least a part of the first portion 210 and the intermediate portion 250 (the x-direction in Figure 6A). In particular, a central one of the blade flexures 262b has a shorter length in the x-direction than the two other blade flexures 262a, 262c. At least one of the rigid body portions 242a, 250 may define one or more rigid protrusions or recesses to accommodate this difference in length of the blade flexures 262a, 262b, 262c in the x-direction. In particular, a rigid protrusion 250a is defined on the intermediate portion 250, the rigid protrusion 250a having an extent in the x-direction that generally matches a difference in extent in the x-direction of the central blade flexure 262b and the two other blade flexures 262a, 262c. It will be appreciated that any other combination of protrusions and/or recesses may be used to allow for an arrangement wherein at least two of the plurality of blade flexures 262a, 262b, 262c have different lengths in the x-direction.

The second hinge portion 240b comprises three blade flexures 264a, 264b, 264c extending from a rigid body portion 244a that forms at least a part of the second portion 220 to a part of the intermediate portion 250. The plurality of blade flexures 264a, 264b, 264c are generally mutually parallel. At least two of the plurality of blade flexures 264a, 264b, 264c have different lengths in a direction extending generally between the rigid body portion 244a that forms at least a part of the second portion 220 and the intermediate portion 250 (the y-direction in Figure 6A). In particular, a central one of the blade flexures 264b has a shorter length in the y-direction than the two other blade flexures 264a, 264c. At least one of the rigid body portions 244a, 250 may define one or more rigid protrusions or recesses to accommodate this difference in length of the blade flexures 264a, 264b, 264c in the x-direction. In particular, a rigid protrusion 250b is defined on the intermediate portion 250, the rigid protrusion 250b having an extent in the y-direction that generally matches a difference in extent in the y-direction of the central blade flexure 264b and the two other blade flexures 264a, 264c. It will be appreciated that any other combination of protrusions and/or recesses may be used to allow for an arrangement wherein at least two of the plurality of blade flexures 264a, 264b, 264c have different lengths in the y-direction.

The third hinge portion 240c comprises three blade flexures 266a, 266b, 266c extending from a rigid body portion 242b that forms at least a part of the first portion 210 to a part of the intermediate portion 250. The plurality of blade flexures 266a, 266b, 266c are generally mutually parallel. At least two of the plurality of blade flexures 266a, 266b, 266c have different lengths in a direction extending generally between the rigid body portion 242b that forms at least a part of the first portion 210 and the intermediate portion 250 (the x-direction in Figure 6A). In particular, a central one of the blade flexures 266b has a shorter length in the x-direction than the two other blade flexures 266a, 266c. At least one of the rigid body portions 242a, 250 may define one or more rigid protrusions or recesses to accommodate this difference in length of the blade flexures 266a, 266b, 266c in the x-direction. In particular, a rigid protrusion 250c is defined on the intermediate portion 250, the rigid protrusion 250c having an extent in the x-direction that generally matches a difference in extent in the x-direction of the central blade flexure 266b and the two other blade flexures 266a, 266c. It will be appreciated that any other combination of protrusions and/or recesses may be used to allow for an arrangement wherein at least two of the plurality of blade flexures 266a, 266b, 266c have different lengths in the x-direction.

The fourth hinge portion 240d comprises three blade flexures 268a, 268b, 268c extending from a rigid body portion 244b that forms at least a part of the second portion 220 to a part of the intermediate portion 250. The plurality of blade flexures 268a, 268b, 268c are generally mutually parallel. At least two of the plurality of blade flexures 268a, 268b, 268c have different lengths in a direction extending generally between the rigid body portion 244b that forms at least a part of the second portion 220 and the intermediate portion 250 (the y-direction in Figure 6A). In particular, a central one of the blade flexures 268b has a shorter length in the y-direction than the two other blade flexures 268a, 268c. At least one of the rigid body portions 244b, 250 may define one or more rigid protrusions or recesses to accommodate this difference in length of the blade flexures 268a, 268b, 268c in the x-direction. In particular, a rigid protrusion 250d is defined on the intermediate portion 250, the rigid protrusion 250d having an extent in the y-direction that generally matches a difference in extent in the y-direction of the central blade flexure 268b and the two other blade flexures 268a, 268c. It will be appreciated that any other combination of protrusions and/or recesses may be used to allow for an arrangement wherein at least two of the plurality of blade flexures 268a, 268b, 268c have different lengths in the y-direction.

Note that if rigid body portions 242b, 244b and the associated flexures (266a, 266b, 266c; 268a, 268b, 268c) that extend between these and the intermediate portion 250 were removed from the linkage 204 shown in Figure 6A, the resultant linkage would be functionally identical to the linkage 202 shown in Figures 5A to 5E (see Figure 5E). The only difference between such a resultant linkage and the linkage 202 shown in Figures 5A to 5E would be the shapes of the rigid body portions 242, 244, 250 in plan view.

Note that, in use, in this embodiment of a linkage 204, the two rigid body portions 242a, 242b that each form at least a part of the first portion 210 are rigidly connected to each other (for example via the first object 212; not shown) and the two rigid body portions 244a, 244b that each form at least a part of the second portion 220 are rigidly connected to each other (for example via the second object 212; not shown). Therefore, the two rigid body portions 242a, 242b that each form at least a part of the first portion 210 may be considered to be a single the rigid body portion and the two rigid body portions 244a, 244b that each form at least a part of the second portion 220 may be considered to be a single the rigid body portion.

Therefore, the hinge 230 of the linkage 204 shown in Figure 6A may be considered to comprise two hinge portions. In particular, the first hinge portion 240a and the third hinge portion 240c may be considered to comprise a single hinge portion (indicated by dot-dashed lines). Furthermore, In particular, the second hinge portion 240b and the fourth hinge portion 240d may be considered to comprise a single hinge portion (indicated by dot-dashed lines).

An additional embodiment of a new linkage 206 is now described with reference to Figure 6B. The new linkage 206 shown in Figure 6B shares some features in common with the new linkage 204 shown in Figure 6A. Where any features of the new linkage 206 shown in Figure 6B are generally equivalent to features of the new linkage 204 shown in Figure 6A they share common reference numerals. Only the differences between the new linkage 206 shown in Figure 6B and the new linkage 204 shown in Figure 6A will be described in detail below.

Similarly to the linkage 204 shown in Figure 6A, the new linkage 206 shown in Figure 6B comprises two rigid body portions 242a, 242b that each forms at least a part of the first portion 210 and two rigid body portions 244a, 244b that each forms at least a part of the second portion 220.

Note that, in use, in this embodiment of a linkage 206, the two rigid body portions 242a, 242b that each form at least a part of the first portion 210 are rigidly connected to each other (for example via the first object 212; not shown) and the two rigid body portions 244a, 244b that each form at least a part of the second portion 220 are rigidly connected to each other (for example via the second object 212; not shown). Therefore, the two rigid body portions 242a, 242b that each form at least a part of the first portion 210 may be considered to be a single the rigid body portion and the two rigid body portions 244a, 244b that each form at least a part of the second portion 220 may be considered to be a single the rigid body portion.

Therefore, the hinge 230 of the linkage 206 shown in Figure 6B may be considered to comprise: a first hinge portion 240a; and a second hinge portion 240b (indicated by dot-dashed lines).

Note that the new linkage 206 shown in Figure 6B comprises generally the same arrangement of blade flexures (262a, 262b, 262c; 264a, 264b, 264c; 266a, 266b, 266c; 268a, 268b, 268c) as are provided in the linkage 204 shown in Figure 6A. However, a shape of the intermediate portion 250 has been altered such that all of the blade flexures in each group of three parallel blade flexures have a common extent between the intermediate portion 250 and an associated rigid body portion 242a, 242b, 244a, 244b. For example, all of the blade flexures 262a, 262b, 262c extending from the rigid body portion 242a that forms at least a part of the first portion 210 to a part of the intermediate portion 250 have the same length; all of the blade flexures 264a, 264b, 264c extending from the rigid body portion 244a that forms at least a part of the second portion 220 to a part of the intermediate portion 250 have the same length; all of the blade flexures 266a, 2665b, 266c extending from the rigid body portion 242b that forms at least a part of the first portion 210 to a part of the intermediate portion 250 have the same length; and all of the blade flexures 268a, 268b, 268c extending from the rigid body portion 244b that forms at least a part of the second portion 220 to a part of the intermediate portion 250 have the same length.

Furthermore, a shape of the intermediate portion 250 has been altered such that: (a) the blade flexures 262a, 262b, 262c extending from a first rigid body portion 242a that forms at least a part of the first portion 210 to a part of the intermediate portion 250 have a different length to the blade flexures 266a, 266b, 262c extending from a second rigid body portion 242b that forms at least a part of the first portion 210 to a part of the intermediate portion 250; and (b) the blade flexures 264a, 264b, 264c extending from a first rigid body portion 244a that forms at least a part of the second portion 220 to a part of the intermediate portion 250 have a different length to the blade flexures 268a, 268b, 268c extending from a second rigid body portion 244b that forms at least a part of the second portion 220 to a part of the intermediate portion 250.

Therefore, the first hinge portion 240a comprises six blade flexures 262a, 262b, 262c, 266a, 266b, 266c extending from a rigid body portion (rigid body portions 242a, 242b rigidly connected together) to the intermediate portion 250. The plurality of blade flexures 262a, 262b, 262c, 266a, 266b, 266c are generally mutually parallel. At least two of the plurality of blade flexures 262a, 262b, 262c, 266a, 266b, 266c have different lengths in a direction extending generally between the rigid body portion 242a, 242b that forms at least a part of the first portion 210 and the intermediate portion 250 (the x-direction in Figure 6B). In particular, blade flexures 266a, 266b, 266c have a shorter length in the x-direction than blade flexures 262a, 262b, 262c.

Similarly, the second hinge portion 240b comprises six blade flexures 264a, 264b, 264c, 268a, 268b, 268c extending from a rigid body portion (rigid body portions 244a, 244b rigidly connected together) to the intermediate portion 250. The plurality of blade flexures 264a, 264b, 264c, 268a, 268b, 268c are generally mutually parallel. At least two of the plurality of blade flexures 264a, 264b, 264c, 268a, 268b, 268c have different lengths in a direction extending generally between the rigid body portion 244a, 244b that forms at least a part of the second portion 220 and the intermediate portion 250 (the y-direction in Figure 6B). In particular, blade flexures 268a, 268b, 268c have a shorter length in the x-direction than blade flexures 264a, 264b, 264c.

An additional embodiment of a new linkage 208 is now described with reference to Figure 6C. The new linkage 208 shown in Figure 6C shares some features in common with the new linkage 204 shown in Figure 6A. Where any features of the new linkage 208 shown in Figure 6C are generally equivalent to features of the new linkage 204 shown in Figure 6A they share common reference numerals. Only the differences between the new linkage 206 shown in Figure 6C and the new linkage 204 shown in Figure 6A will be described in detail below.

Similarly to the linkage 204 shown in Figure 6A, the new linkage 206 shown in Figure 6B comprises two rigid body portions 242a, 242b that each forms at least a part of the first portion 210 and two rigid body portions 244a, 244b that each forms at least a part of the second portion 220.

Note that, in use, in this embodiment of a linkage 208, the two rigid body portions 242a, 242b that each form at least a part of the first portion 210 are rigidly connected to each other (for example via the first object 212; not shown) and the two rigid body portions 244a, 244b that each form at least a part of the second portion 220 are rigidly connected to each other (for example via the second object 212; not shown). Therefore, the two rigid body portions 242a, 242b that each form at least a part of the first portion 210 may be considered to be a single the rigid body portion and the two rigid body portions 244a, 244b that each form at least a part of the second portion 220 may be considered to be a single the rigid body portion.

Therefore, the hinge 230 of the linkage 208 shown in Figure 6C may be considered to comprise: a first hinge portion 240a; and a second hinge portion 240b (indicated by dot-dashed lines).

Note that the new linkage 208 shown in Figure 6C comprises a similar arrangement of blade flexures (272a, 272b; 274a, 274b; 276a, 276b; 278a, 278b) as are provided in the linkage 204 shown in Figure 6A. However, each of the rigid body portions 242a, 242b, 244a, 244b that form part of the first portion 210 and the second portion 220 is connected to the intermediate portion 250 via two blade flexures (272a, 272b; 274a, 274b; 276a, 276b; 278a, 278b) rather than three blade flexures (as was the case for the new linkage 204 shown in Figure 6A).

As with the new linkage 204 shown in Figure 6A, each of the rigid body portions 242a, 242b, 244a, 244b that form part of the first portion 210 and the second portion 220 is connected to the intermediate portion 250 via blade flexures (272a, 272b; 274a, 274b; 276a, 276b; 278a, 278b) that have different extents.

Therefore, the first hinge portion 240a comprises four blade flexures 272a, 272b, 276a, 276b extending from a rigid body portion (rigid body portions 242a, 242b rigidly connected together) to the intermediate portion 250. The plurality of blade flexures 272a, 272b, 276a, 276b are generally mutually parallel. At least two of the plurality of blade flexures 272a, 272b, 276a, 276b have different lengths in a direction extending generally between the rigid body portion 242a, 242b that forms at least a part of the first portion 210 and the intermediate portion 250 (the x-direction in Figure 6C). In particular, blade flexures 272a, 276a have a shorter length in the x-direction than blade flexures 272b, 276b.

Similarly, the second hinge portion 240b comprises four blade flexures 274a, 274b, 278a, 278b extending from a rigid body portion (rigid body portions 244a, 244b rigidly connected together) to the intermediate portion 250. The plurality of blade flexures 274a, 274b, 278a, 278b are generally mutually parallel. At least two of the plurality of blade flexures 274a, 274b, 278a, 278b have different lengths in a direction extending generally between the rigid body portion 244a, 244b that forms at least a part of the second portion 220 and the intermediate portion 250 (the y-direction in Figure 6C). In particular, blade flexures 274a, 278a have a shorter length in the x-direction than 274b, 278b.

Note that, in general, a linkage 200, 202, 204, 206, 208 according to an embodiment of the present disclosure comprises at least one hinge portion that comprises a plurality of blade flexures extending from a first rigid body portion of the linkage to a second rigid body portion of the linkage, wherein the plurality of blade flexures are generally mutually parallel and wherein at least two of the plurality of blade flexures have different lengths in a direction extending generally between the first rigid body portion and the second rigid body portion. As discussed above, this gives rise to a conflict which will depend on the distortion parameter, *θ*. In turn, this results in a restoring torque that has a non-linear dependence on the distortion parameter, *θ*.

In some embodiments, this conflict will also result in a torque about a direction in which the first member 212 is separated from the second member 222 (the z-direction in the Figures). In general, as the blade flexures are flexed they will apply different forces to the rigid bodies that they extend between in the direction of their extent. For example, in a frame of reference in which one the rigid bodies does not move, as the blade flexures are flexed, the blade flexures will exert forces on the other rigid body in a direction parallel to their extent, the forces being dependent on their extent.

As an example, consider the arrangement shown in Figure 6A. Consider rotation about the y-axis (also referred to as Ry), which is accommodated by the blade flexures 262a, 262b, 262c, 266a, 266b, 266c (which extend in the x-direction). In a frame of reference in which the two rigid body portions 242a, 242b do not move, as these blade flexures 262a, 262b, 262c, 266a, 266b, 266c are flexed they will each apply a force on the intermediate portion 250 having a component in the x-direction. The direction of this x-component of force is dependent on the extent of the blade flexures 262a, 262b, 262c, 266a, 266b, 266c. In particular, the shorter blade flexures 262b, 266b will exert a force in one x-direction and the longer blade flexures 262a, 262c, 266a, 266c will exert a force in the opposite x-direction. In general, these forces will result in a torque on the intermediate portion 250 that will tend to rotate it about the z-axis (also referred to as Rz). However, with the arrangement shown in Figure 6A, the blade flexures 262a, 262b, 262c, 266a, 266b, 266c are arranged in symmetric manner such that a total torque that contributes to Rz rotation is zero.

For example, consider rotation of the intermediate portion 250 about its center point. Recall that the torque *τ* about a point caused by a force F is given by *τ* = ***r*** × ***F***, where r is a vector extending from the point to the where the force is applied. Advantageously, the arrangement of blade flexures in the linkage 204 shown in Figure 6A is such that the total torque on the intermediate portion 250 that will tend to rotate it about the z-axis (also referred to as Rz) when the blade flexures are flexed is zero. Similarly, the arrangement of blade flexures in the linkage 208 shown in Figure 6C is such that the total torque on the intermediate portion 250 that will tend to rotate it about the z-axis (also referred to as Rz) when the blade flexures are flexed is zero.

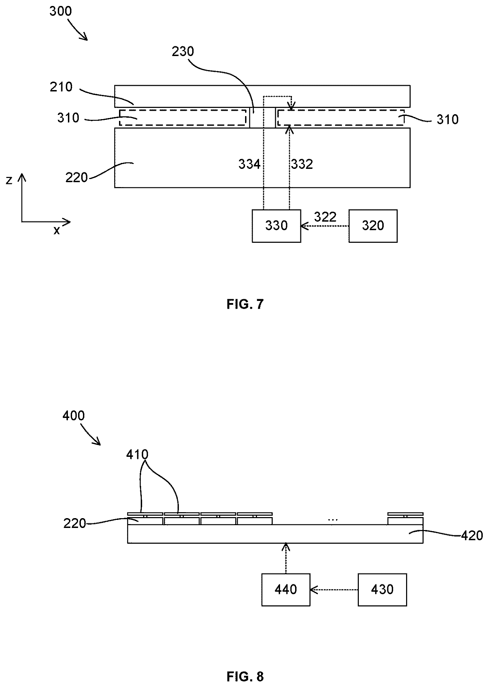

Some embodiments of the present disclosure relate to an actuator comprising: a linkage 200, 202, 204, 206, 208 according to an embodiment of the present disclosure. An example of such an actuator 300 is shown schematically in Figure 7. In addition to the linkage 200, 202, 204, 206, 208, the actuator 300 further comprises an actuation mechanism 310 operable to apply an actuation force so as to cause relative movement of first and second portions 210, 220 of the linkage 200, 202, 204, 206, 208. The actuator 300 may be generally of the form of the actuator 100 shown in Figures 3A to 3C and described above. For example, the actuation mechanism 310 may comprise the actuation mechanism 130 shown in Figures 3A to 3C and described above.

The actuator 300 comprising a linkage 200, 202, 204, 206, 208 according to an embodiment of the present disclosure may be used to support, and control an orientation of, a rotatable mirror. For example, the first portion 210 may support a mirror and the second portion 220 may be, or be connected to, a fixed support. In use, the actuation mechanism 310 may be used to apply an actuation force, or actuation torque, in order to achieve a desired orientation of the mirror relative to the fixed support.

In general, the actuation force applied by the actuator may be dependent on an actuation parameter and a relative position of the first and second portions 210, 220. For example, the actuator 300 may be an electrostatic actuator and the actuation force may be dependent on an applied voltage. The actuation parameter may be dependent on the applied voltage; for example the actuation parameter may be *Vⁿ*, where V is the applied voltage. Furthermore, the actuation force may be dependent on a relative position of the first and second portions 210, 220. For example, the actuation force, *Fₐ*, may be given by *Fₐ = g*₁ · *θ* · *Vⁿ*, where *g*₁ is a gain of the actuator 300 and *θ* is a deformation parameter that characterizes a relative position of the first and second members 210, 220. If *g*₁ is a constant then the actuation force may be considered to have a linear dependence on the relative position of the first and second portions 210, 220.

The hinge portion(s) 240, 240a, 240b, 240c, 240d couple the first and second portions 210, 220 together and may apply a restoring force in the event that an actuation force is applied. The restoring force may generally act so as to oppose the actuation force and to urge the first and second portions 210, 220 back to a nominal or equilibrium relative position.

Upon application of an actuation force, the actuator 300 will adopt a steady-state position in which the sum of the forces (and/or torques) acting upon the second member is zero. That is, in steady state, *Fₐ* = *-Fᵣ*.

In some embodiments, at least one hinge portion 240, 240a, 240b, 240c, 240d of the linkage 200, 202, 204, 206, 208 has a non-linear response such that a restoring force applied by said at least one hinge portion 240, 240a, 240b, 240c, 240d at least partially compensates for a non-linear dependence of the actuation force on a relative position of the first and second members 210, 220.

It will be appreciated that the relative position of the first and second members 210, 220 may be a relative angular position of the first and second members 210, 220.

The actuator 300 comprising a linkage 200, 202, 204, 206, 208 according to an embodiment of the present disclosure may be any type of actuator but in one example embodiment it may comprise an electrostatic actuator, for example an electrostatic comb actuator.

For example, in some embodiments, the actuator 300 may comprise an electrostatic actuator wherein movement of the first portion 210 relative to the second portion 220 is achieved by controlling a potential difference between one of more actuator conductors disposed on the second portion 220 and one or more corresponding actuator conductors disposed on the first portion 210. For example, the actuation mechanism 310 may comprise a plurality of conductors similar to the actuator conductors 132 and the second actuator conductors 134 of the actuation mechanism 130 described above with reference to Figures 3A to 3C.

In some embodiments, the actuator 300 comprising a linkage 200, 202, 204, 206, 208 according to an embodiment of the present disclosure may comprise a comb-drive.

In some embodiments, the actuator 300 comprising a linkage 200, 202, 204, 206, 208 according to an embodiment of the present disclosure may comprise a micro-electromechanical system.

In some embodiments, the actuator 300 comprising a linkage 200, 202, 204, 206, 208 according to an embodiment of the present disclosure may further comprise a controller 320 operable to control a voltage of one or more components of the actuation mechanism 310.

In some embodiments, the actuator 300 comprising a linkage 200, 202, 204, 206, 208 according to an embodiment of the present disclosure may further comprise a voltage supply 330 operable to apply a voltage to one or more components of the actuation mechanism 310.

The controller 320 may be operable to control the voltage supply 330 via one or more control signals 322. In turn, the voltage supply 330 may be operable to apply voltages to parts of the actuation mechanism via electrical contacts 332, 334. Note that, in some embodiments, the electrical contacts 334 that allow the voltage supply 330 to apply voltages to parts of the actuation mechanism disposed on the first portion 210 may pass through the hinge 230. In particular, the electrical contacts 334 may be at least partially formed on, or at least partially comprise, one or more flexures of the at least one hinge portion 240, 240a, 240b, 240c, 240d.

Some embodiments of the present disclosure relate to an apparatus comprising a plurality of individual optical elements, each comprising a linkage 200, 202, 204, 206, 208 according to an embodiment of the present disclosure and/or an actuator 300 of the type shown in Figure 7.

Such an apparatus 400 is shown schematically in Figure 8. In addition to the plurality of individual optical elements 410, the apparatus 400 comprises a common support 420. The second portion 220 of each of the plurality of individual optical elements is supported by the common support 420.

Such an apparatus 400 may be for use in an illumination system IL of a lithographic apparatus LA of the type shown in Figure 1. Such an arrangement may be referred to as a MEMS micro-mirror array. The apparatus 400 may form the facetted field mirror device 10 and/or the facetted pupil mirror device 11 of the type shown in Figure 1 and as described above.

In some embodiments, a reflective optical surface is supported by the first portion 210 of at least one of the plurality of individual optical elements 410. In some embodiments, a reflective optical surface is supported by the first portion 210 of each of the plurality of individual optical elements 410. The reflective optical surface may be reflective for extreme ultraviolet (EUV) radiation. The reflective optical surface may comprise a multilayer mirror (also known as a Bragg mirror). The reflective optical surface may have dimensions of the order of 1 mm by 1 mm.

In some embodiments, the apparatus 400 may further comprise a controller 430 operable to control a voltage of one or more components of the actuation mechanism 310 of at least one of the plurality of individual optical elements 410. In some embodiments, the controller 430 may be operable to control a voltage of one or more components of the actuation mechanism 310 of each of the plurality of individual optical elements 410.

In some embodiments, the apparatus 400 may further comprising a voltage supply 440 operable to apply a voltage to one or more components of the actuation mechanism 310 of at least one of the plurality of individual optical elements 410. In some embodiments, the voltage supply 440 may be operable to apply a voltage to one or more components of the actuation mechanism 310 of each of the plurality of individual optical elements 410.

It will be appreciated that the controller 430 and the voltage supply 440 of the apparatus 400 may have the same functionality as the controller 320 and voltage supply 330 of the actuator 300 shown in Figure 7 and described above.

Some embodiments of the present disclosure relate to an illumination system comprising at least one apparatus 400 of the type shown in Figure 8. The illumination system may be suitable for use as the illumination system IL of a lithographic apparatus shown in Figure 1. Some embodiments of the present disclosure relate to a lithographic apparatus, a metrology apparatus and/or an inspection apparatus comprising such an illumination system.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A linkage for an actuator, the linkage comprising:
a first portion;
a second portion; and
a hinge, wherein the first portion is connected to the second portion via the hinge and wherein the hinge comprises at least one hinge portion, the or each hinge portion comprising a plurality of blade flexures extending from a first rigid body portion of the linkage to a second rigid body portion of the linkage, wherein the plurality of blade flexures are generally mutually parallel and wherein at least two of the plurality of blade flexures have different lengths in a direction extending generally between the first rigid body portion and the second rigid body portion.

2. A linkage of claim 1 wherein the or each hinge portion is formed as a monolithic structure.

3. The linkage of any preceding claim wherein at least a part of the first rigid body portion, at least a part of the second rigid body portion and the plurality of blade flexures of the or each hinge portion are formed from a single crystal.

4. The linkage of any preceding claim wherein the hinge is such that the first portion can rotate relative to the second portion in two degrees of freedom.

5. The linkage of any preceding claim further comprising an intermediate portion and wherein the hinge comprises at least two hinge portions of the type described in claim 1, the at least two hinge portions comprising:
at least one first hinge portion wherein the first rigid body portion of the or each at least one first hinge portion forms at least a part of the first portion and the second rigid body portion of the or each at least one first hinge portion forms at least a part of the intermediate portion; and
at least one second hinge portion wherein the first rigid body portion of the or each at least one first hinge portion forms at least a part of the intermediate portion and the second rigid body portion of the or each at least one first hinge portion forms at least a part of the second portion.

6. The linkage of any one of claims 1 to 4 further comprising an intermediate portion and wherein the hinge comprises:
at least one first hinge portion comprising a plurality of blade flexures extending from a rigid body portion that forms at least a part of the first portion to a rigid body portion that forms at least a part of the intermediate portion, wherein the plurality of blade flexures are generally mutually parallel and wherein at least two of the plurality of blade flexures have different lengths in a direction extending generally between the rigid body portion that forms at least a part of the first portion and the rigid body portion that forms at least a part of the intermediate portion; and
at least one second hinge portion comprising: a plurality of blade flexures extending from a rigid body portion that forms at least a part of the intermediate portion to a rigid body portion that forms at least a part of the second portion, wherein the plurality of blade flexures are generally mutually parallel and wherein at least two of the plurality of blade flexures have different lengths between the rigid body portion that forms at least a part of the intermediate portion and the rigid body portion that forms at least a part of the second portion.

7. The linkage of any one of claim 5 or claim 6 wherein the at least one first hinge portion allows the first portion to rotate relative to the second portion in a first degree of freedom and wherein the at least one second hinge portion allows the first portion to rotate relative to the second portion in a second, different degree of freedom.

8. The linkage of any preceding claim wherein the first portion comprises a first member and the second portion comprises a second member.

9. The linkage of any preceding claim wherein the first portion comprises a member having two larger dimensions in first and second directions, which define a plane of the member.

10. The linkage of claim 9 wherein the hinge is disposed at a central portion of the plane of the member of the first portion.

11. The linkage of any one of claims 8 to 10 wherein the member of the first portion comprises or defines a reflective optical surface.

12. The linkage of any preceding claim wherein at least one hinge portion of the linkage has a non-linear response.

13. The linkage of any preceding claim wherein the plurality of blade flexures of at least one hinge portion are arranged such that as they are distorted torques exerted on the first portion and/or second portions by the plurality of blade flexures that cause rotation of the first portion relative to the second portion about a direction in which the first member is separated from the second member at least partially cancel out.

14. The linkage of any preceding claim wherein the plurality of blade flexures of at least one hinge portion are arranged such that as they are distorted a total torque exerted on the first portion and/or second portions by the plurality of blade flexures that cause rotation of the first portion relative to the second portion about a direction in which the first member is separated from the second member is zero.

15. An actuator comprising:
the linkage of any preceding claim; and
an actuation mechanism operable to apply an actuation force so as to cause relative movement of first and second portions of the linkage.

16. The actuator of claim 15 wherein at least one hinge portion of the linkage has a non-linear response such that a restoring force applied by said at least one hinge portion at least partially compensates for a non-linear dependence of the actuation force on a relative position of the first and second members.

17. The actuator of claim 15 or claim 16 wherein the actuator comprises an electrostatic actuator and wherein movement of the first portion relative to the second portion is achieved by controlling a potential difference between one of more actuator conductors disposed on the second portion and one or more corresponding actuator conductors disposed on the first portion.

18. The actuator of any one of claims 15 to 17 wherein the actuator comprises a comb-drive.

19. The actuator of any one of claims 15 to 18 wherein the actuator comprises a micro-electromechanical system.

20. The actuator of any one of claims 15 to 19 further comprising a controller operable to control a voltage of one or more components of the actuation mechanism.

21. The actuator of any one of claims 15 to 20 further comprising a voltage supply operable to apply a voltage to one or more components of the actuation mechanism.

22. An apparatus comprising:
a plurality of individual optical elements, each comprising the linkage of any one of claims 1 to 14 and/or an actuator of any one of claims 15 to 21; and
a support;
wherein a second portion of each of the plurality of individual optical elements is supported by the support.

23. The apparatus of claim 22 comprising a reflective optical surface supported by the first portion of at least one of the plurality of individual optical elements.

24. The apparatus of claim 22 or claim 23 when dependent either directly or indirectly on claim 13 further comprising a controller operable to control a voltage of one or more components of the actuation mechanism of at least one of the plurality of individual optical elements.

25. The apparatus of any one of claims 22 to 24 when dependent either directly or indirectly on claim 15 further comprising a voltage supply operable to apply a voltage to one or more components of the actuation mechanism of at least one of the plurality of individual optical elements.

26. An illumination system comprising at least one apparatus according to one of claims 22 to 25.

27. A lithographic apparatus comprising the illumination system of claim 26.

28. A metrology apparatus comprising the illumination system of claim 26.

29. An inspection apparatus comprising the illumination system of claim 26.
